# EUROPEAN PATENT APPLICATION

(11) **EP 2 890 014 A1**
(43) Date of publication of application: **01.07.2015**
(21) Application number: 14275091.8
(22) Date of filing: 24.04.2014
(51) Int. Cl.: H03L 7/16, H03L 7/18, H03K 23/66

(54) **Digital divider and frequency synthesizer using the same**

(30) Priority: 27.12.2013 KR 20130165715
(71) Applicant: Samsung Electro-Mechanics Co., Ltd., Gyeonggi-do (KR)
(72) Inventor: Kim, Myeung Su, Gyeonggi-Do (KR); Lee, Jae Hyung, Gyeonggi-Do (KR)
(74) Representative: Potter Clarkson LLP

(57) **Abstract**

A digital divider may include: a dividing unit including a plurality of logical dividing elements; and a division controlling unit receiving an input signal and outputs of the plurality of logical dividing elements and outputting a divided signal generated by dividing the input signal by a predetermined dividing ratio using the outputs of the plurality of logical dividing elements.

## Description

### CROSS-REFERENCE TO RELATED APPLICATION

This application claims the benefit of Korean Patent Application No. 10-2013-0165715 filed on December 27, 2013, with the Korean Intellectual Property Office, the disclosure of which is incorporated herein by reference.

### BACKGROUND

The present disclosure relates to a digital divider and a frequency synthesizer using the same.

In the field of wireless communications, a frequency synthesizer has been widely used in order to generate stable frequencies for transmission and reception.

The miniaturization of frequency synthesizers has recently been required. That is, in accordance with implementing compactness in electronic devices, demand for miniaturization of frequency synthesizers has increased.

As such a frequency synthesizer, a phase locked loop (PLL) including a voltage controlled oscillator has been used. However, a frequency synthesizer according to the related art is configured based on an analog circuit.

Particularly, a divider required in the frequency synthesizer has mainly used an analog scheme. As such a divider using an analog scheme, a pulse swallow divider, or the like, has been used.

Such a pulse swallow divider necessarily requires a plurality of counters such as a P counter, an S counter, and the like, in order to perform division in 1/N or 1/N+1.

Therefore, there is a limitation in that a size of the frequency synthesizer or the phase locked loop may be large.

The following Patent Document 1 relates to a frequency divider and a phase locked loop apparatus using the same, and Patent Document 2 relates to a phase locked loop circuit and a frequency modulation method in the same. However, Patent Documents 1 and 2 still have the above-mentioned limitation in that a plurality of counters are required or an analog divider is used.

### [Related Art Document]

(Patent Document 1) Korean Patent Laid-Open Publication No. 10-2006-0122541
(Patent Document 2) Korea Patent Publication No. 10-0360995

### SUMMARY

An aspect of the present disclosure may provide a digital divider capable of having a simple structure and being miniaturized, and a frequency synthesizer using the same.

According to an aspect of the present disclosure, a digital divider may include: a dividing unit including a plurality of logical dividing elements; and a division controlling unit receiving an input signal and outputs of the plurality of logical dividing elements and outputting a divided signal generated by dividing the input signal by a predetermined dividing ratio using the outputs of the plurality of logical dividing elements.

The dividing unit may be configured of a plurality of flip-flops connected in series with each other, each of the plurality of flip-flops performing 2-divisions.

The division controlling unit may output an output of any one of the plurality of logical dividing elements as the divided signal when the dividing ratio is 2^{N}.

The division controlling unit may determine the dividing ratio using a dividing ratio signal of 50% when the dividing ratio is an even number other than 2^{N}.

The division controlling unit may include a multiplexer receiving the outputs of the plurality of logical dividing elements and outputting any one of the outputs of the plurality of logical dividing elements as the dividing signal.

The division controlling unit may apply an ON time during a time of N/2+0.5 and apply an OFF time during a time of N/2-0.5 when the dividing ratio is an odd number, thereby determining the odd numbered dividing ratio.

According to another aspect of the present disclosure, a frequency synthesizer may include: an analog circuit unit detecting differences between phases and frequencies of a reference signal and a divided signal, varying a frequency depending on the differences, and outputting an oscillation signal having the varied frequency; and a digital circuit unit dividing an output frequency of the oscillation signal and feeding back the divided signal to the analog circuit unit.

The analog circuit unit may include: a phase comparator receiving the divided signal and the reference signal and outputting a phase difference between the frequencies of the divided signal and the reference signal; and a voltage controlled oscillator receiving a control signal corresponding to the phase difference and outputting a new oscillation signal depending on the control signal.

The analog circuit unit may include: a charge pump charging or discharging charges in or from a capacitor depending on the phase difference output from the phase comparator; and a filter generating the control signal using a current output from the charge pump.

The digital circuit unit may include a digital divider dividing an output frequency of the oscillation signal at a predetermined ratio and inputting the oscillation signal of which the output frequency is divided as the divided signal to the phase comparator.

The digital divider may include: a dividing unit including a plurality of logical dividing elements; and a division controlling unit receiving the oscillation signal and outputs of the plurality of logical dividing elements and outputting a divided signal generated by dividing the oscillation signal by a predetermined dividing ratio using the outputs of the plurality of logical dividing elements.

The dividing unit may be configured of a plurality of flip-flops connected in series with each other, each of the plurality of flip-flops performing 2-divisions.

The division controlling unit may determine the dividing ratio using a dividing ratio signal of 50% when the dividing ratio is an even number other than 2^{N}. The division controlling unit may determine the dividing ratio using a dividing ratio signal of 50% when the dividing ratio is an even number other than 2^{N}.

The division controlling unit may include a multiplexer receiving the outputs of the plurality of logical dividing elements and outputting any one of the received signals as the dividing signal.

The division controlling unit may apply an ON time during a time of N/2+0.5 and apply an OFF time during a time of N/2-0.5 when the dividing ratio is an odd number, determining the odd numbered dividing ratio.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a configuration diagram illustrating a general frequency synthesizer;
FIG. 2 is a configuration diagram illustrating a frequency synthesizer according to an exemplary embodiment of the present disclosure;
FIG. 3 is a configuration diagram illustrating an example of a digital divider of FIG. 2;
FIG. 4 is a reference diagram illustrating an output signal of the digital divider according to an exemplary embodiment of the present disclosure;
FIG. 5 is a reference diagram for describing division of the digital divider according to an exemplary embodiment of the present disclosure;
FIG. 6 is a reference diagram for describing an example of another output of the digital divider according to an exemplary embodiment of the present disclosure; and
FIG. 7 is a reference graph illustrating simulation data according to an exemplary embodiment of the present disclosure.

### DETAILED DESCRIPTION

Hereinafter, embodiments of the present disclosure will be described in detail with reference to the accompanying drawings. The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art. Throughout the drawings, the same or like reference numerals will be used to designate the same or like elements.

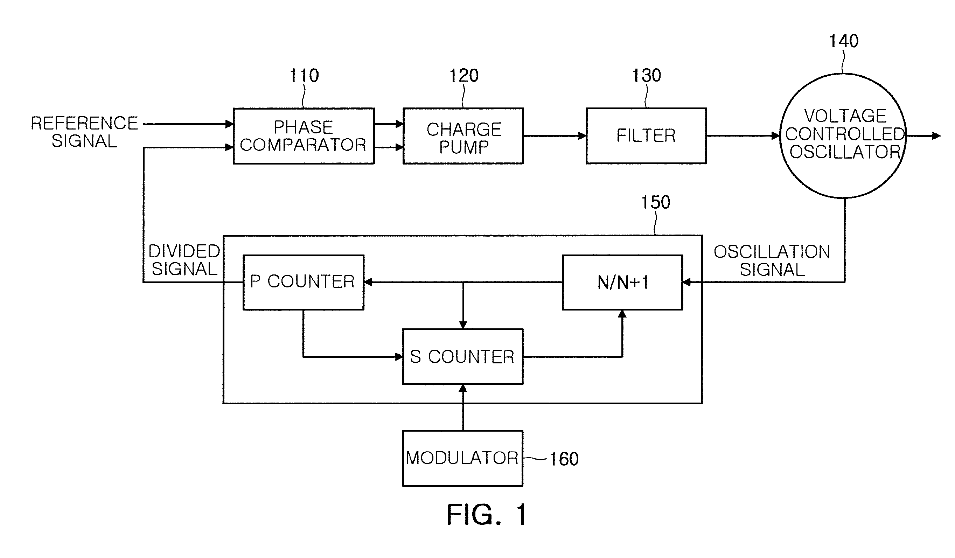

FIG. 1 is a configuration diagram illustrating a general frequency synthesizer.

A frequency synthesizer illustrated in FIG. 1 may include a phase comparator 110, a charge pump 120, a filter 130, a voltage controlled oscillator 140, a divider 150, and a modulator 160. The modulator 160 may provide a modulation signal to the divider 150 to control modulation.

The divider 150 illustrated in FIG. 1 may be a pulse swallow divider. That is, the divider 150 may use a pulse swallow scheme of performing division in 1/N or 1/N+1.

The divider 150 may include a pre-scaler dividing an oscillation signal in 1/P or 1/(P+1), a P counter having a dividing ratio of 1/M and counting pulses output from the pre-scaler, and an S counter selecting and controlling a dividing ratio of the pre-scaler to be 1/P or 1/(P+1) depending on the a counted value of the P counter 22.

As described above, in the frequency synthesizer illustrated in FIG. 1, components other than the modulator 160 may be configured of an analog circuit.

Particularly, since the pulse swallow divider 150 implemented by the analog circuit requires a plurality of counters such as the P counter, the S counter, and the like, there is a limitation that a size of the pulse swallow divider 150 is increased when the pulse swallow divider 150 is actually implemented.

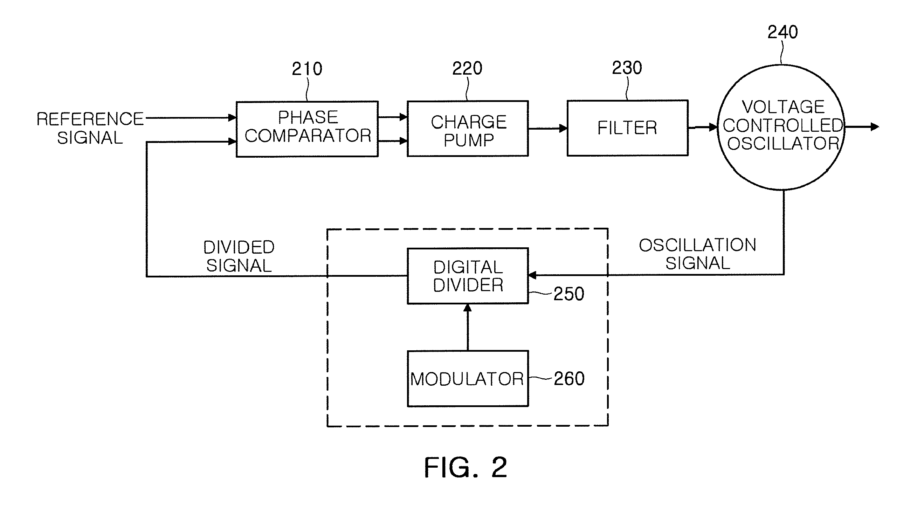

FIG. 2 is a configuration diagram illustrating a frequency synthesizer according to an exemplary embodiment of the present disclosure.

Referring to FIG. 2, a frequency synthesizer according to an exemplary embodiment of the present disclosure may include an analog circuit unit and a digital circuit unit.

The analog circuit unit, which is a circuit detecting differences between phases and frequencies of a reference signal and a divided signal, varying a frequency depending on the differences, and outputting an oscillation signal having the varied frequency, may include a phase comparator 210, a charge pump 220, a filter 230, and a voltage controlled oscillator 240.

The digital circuit unit, which is a circuit dividing an output frequency of the oscillation signal and feeding back the divided signal to the analog circuit unit, may include a digital divider 250 and a modulator 260.

That is, in the frequency synthesizer according to an exemplary embodiment of the present disclosure, the digital divider 250 configured of a digital circuit is used. According to an exemplary embodiment of the present disclosure, the digital divider 250 and the modulator 260 may be implemented as one integrated circuit.

The phase comparator 210 may receive the reference signal and the divided signal and compare phases of frequencies of the reference signal and the divided signal with each other. The phase comparator 210 may provide an output signal corresponding to a phase difference between the reference signal and the divided signal to the charge pump 220.

The charge pump 220 may receive an output signal of the phase comparator 210 and output a current corresponding to the output signal.

In an exemplary embodiment of the present disclosure, the charge pump 220 may charge or discharge charges in or from a capacitor depending on the phase difference output from the phase comparator 210, thereby outputting a signal corresponding to the phase difference.

The current output from the charge pump 220 may be input to the filter 230, and the filter 230 may convert the input current into a voltage and provide the voltage to the voltage controlled oscillator 240. Here, the voltage output from the filter 230 may be used as a control signal of the voltage controlled oscillator 240.

The voltage controlled oscillator 240 may receive the control signal corresponding to the phase difference between the reference signal and the divided signal and output a new oscillation signal depending on the control signal.

The output signal, that is, the new oscillation signal, of the voltage controlled oscillator 240 may be divided by the divider 250 and be then fed back to the phase comparator 210.

The digital divider 250 may divide the oscillation signal output from the voltage controlled oscillator 240 at a predetermined ratio. For example, the divider 250 may divide the oscillation signal so as to have the same frequency as that of the reference signal to generate the divided signal. Here, the above-mentioned reference signal, oscillation signal, and divided signal may be voltage signals.

In addition, the digital divider 250 may reflect a modulation signal provided from the modulator 260 to provide a modified divided signal to the phase comparator 210.

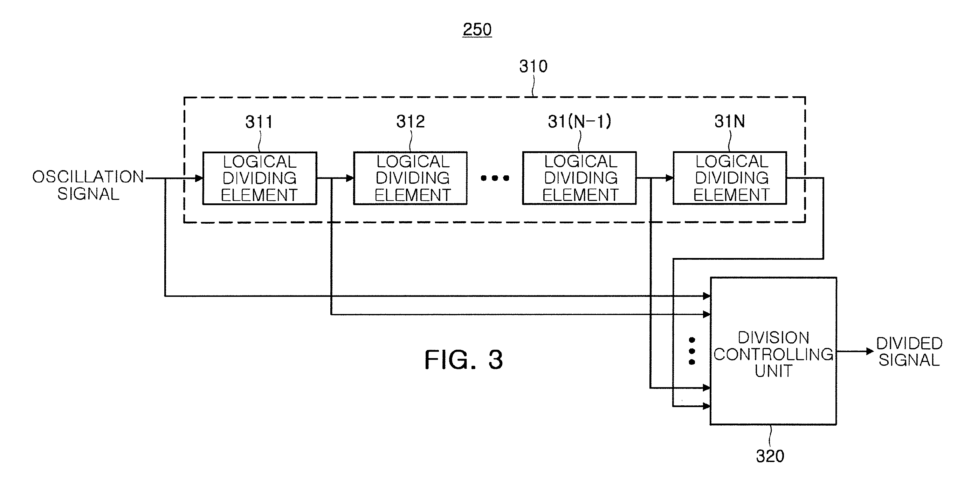

FIG. 3 is a configuration diagram illustrating an example of a digital divider of FIG. 2. Hereinafter, a digital divider will be described in more detail with reference to FIG. 3.

Referring to FIG. 3, the digital divider 250 may include a dividing unit 310 including a plurality of logical dividing elements and a division controlling unit 320 outputting the divided signal using an output of the dividing unit.

In an exemplary embodiment of the present disclosure, the dividing unit 310 may include the plurality of logical dividing elements 311 to 31N connected in series with each other. For example, the dividing unit 310 may be configured of a plurality of flip-flops connected in series with each other. Here, each of the flip-flops may perform 2-divisions.

The division controlling unit 320 may receive an input signal and outputs of the plurality of logical dividing elements and output a divided signal generated by dividing the input signal by a predetermined dividing ratio using the outputs of the plurality of logical dividing elements. Here, the input signal may be the oscillation signal.

In an exemplary embodiment of the present disclosure, the division controlling unit 320 may be differently operated depending on whether or the dividing ratio is an odd number or an even number (dividing ratio other than 2ⁿ is differently operated).

As an example, when the dividing ratio is 2ⁿ, the division controlling unit 320 may output an output of any one of the plurality of logical dividing elements as the divided signal. That is, since each of the logical dividing elements of the digital divider 250 performs the 2-division, the output of the logical dividing element may be used as the dividing signal.

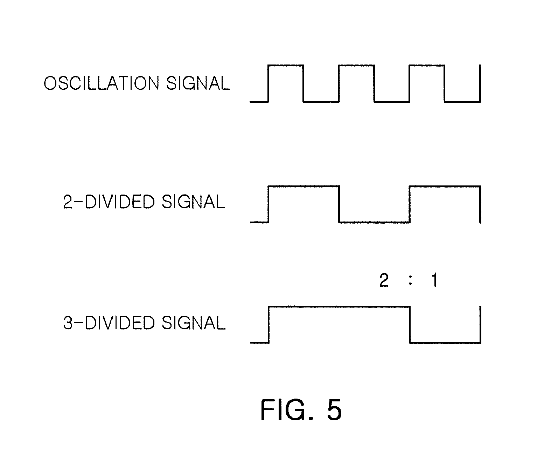

As another example, when the dividing ratio is the odd number, the division controlling unit 320 may determine the dividing ratio of the odd number by N/2+0.5 and N/2-0.5 to control the division. This will be described in more detail with reference to FIG. 5.

In an exemplary embodiment of the present disclosure, in the case in which only an even-numbered dividing ratio is required, the division controlling unit 320 may be simply implemented by a multiplexer element. That is, the division controlling unit 320 may be implemented by a multiplexer receiving the outputs of the plurality of logical dividing elements and outputting any one of the outputs of the plurality of logical dividing elements as the divided signal.

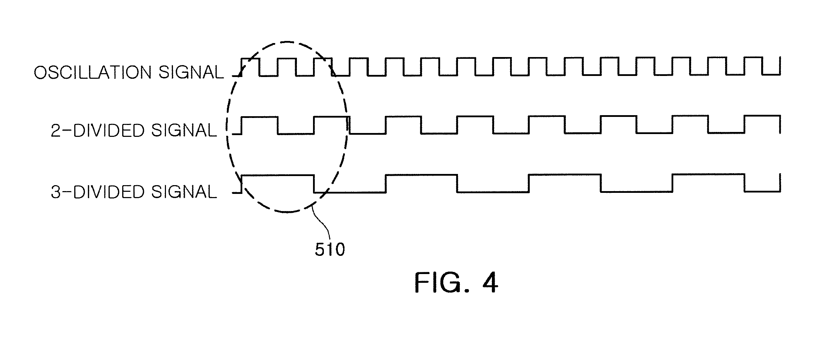

The division controlling unit 320 will be described below in more detail with reference to FIGS. 4 through 6.

FIG. 4 is a reference diagram illustrating an output signal of the digital divider according to an exemplary embodiment of the present disclosure; and FIG. 5 is a reference diagram for describing division of the digital divider according to an exemplary embodiment of the present disclosure.

FIG. 4 shows an oscillation signal input to the digital divider, and a 2-divided signal and a 3-divided signal of the oscillation signal. FIG. 5 shows enlarged signals of a reference numeral of FIG. 4.

Hereinafter, a driving operation of the digital divider will be described with reference to FIGS. 3 through 5.

Since an output of a first logical dividing element 311 corresponds to a 2ⁿ divided signal, in the case in which the dividing ratio is 2, an output of the first logical dividing element 311 may be output as a 2-divided signal. Likewise, in the case in which the dividing ratio is 4, an output of a second logical dividing element 312 may output as a 4-divided signal.

That is, when the dividing ratio corresponds to 2ⁿ, the divided signal may be simply generated by using any one of the outputs of the logical dividing elements 311 connected in series with each other.

Meanwhile, in the case in which the dividing ratio is an even numbered ratio (6, 10, or the like) other than2ⁿ, the division may be performed using a dividing ratio signal of 50%. For example, in the case in which the division ratio is 6, the division may be performed using a dividing ratio of 50% of the 2-divided signal.

On the other hand, in the case in which the dividing ratio is an odd number, the dividing ratio may not be satisfied by only the outputs of the logical dividing elements 311 to 31N themselves. Therefore, the division controlling unit 320 needs to perform separate processing.

To this end, the dividing controlling unit 320 may determine an odd dividing ratio by a combination of N/2+0.5 and N/2-0.5. That is, in the case of the 3-division illustrated, the 3-division may be determined by a combination 2 and 1. When it is generalized, the odd numbered dividing ratio N may have a duty ratio of N/2+0.5 and N/2-0.5.

Then, the division controlling unit 320 may set a time corresponding to N/2+0.5 to an ON time and set a time corresponding to N/2-0.5 to an OFF time to generate a divided signal having an odd number period. Here, the ON time and the OFF time are only example, and the division controlling unit 320 may set the time corresponding to N/2+0.5 to the ON time and set the time corresponding to N/2-0.5 to the OFF time.

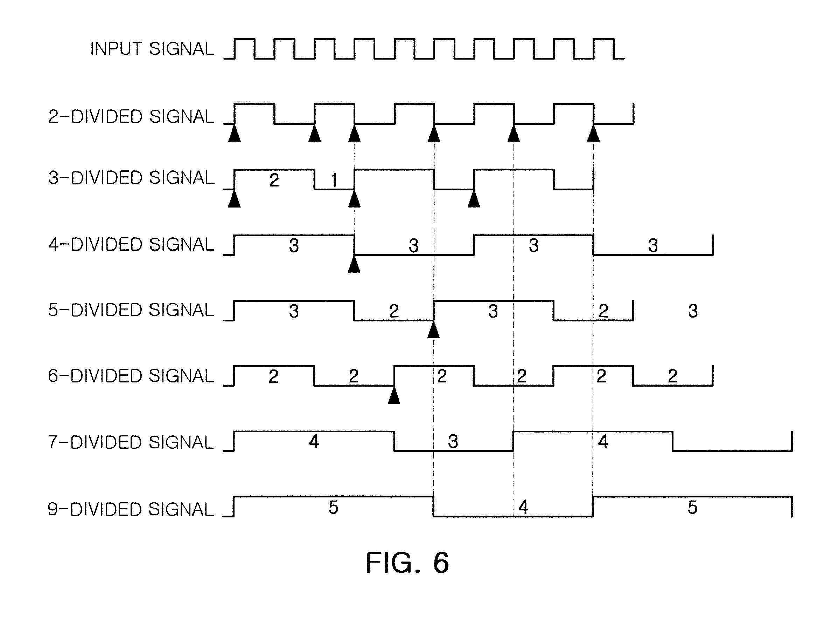

FIG. 6 is a reference diagram for describing an example of another output of the digital divider according to an exemplary embodiment of the present disclosure.

In FIG. 6, a 2-divided signal, a 3-divided signal, a 6-divided signal, a 5-divided signal, a 7-divided signal, and a 9-divided signal for the input signal are illustrated.

As described above, when the dividing ratio corresponds to 2ⁿ, the divided signal may be generated as any one of the outputs of the logical dividing elements 310 connected in series with each other.

In the case of an example of 3-division, a 3-divided signal may be generated so as to have a high value during one period of a 2-divided signal and have a low value during a 50% duty cycle of the 2-divided signal (that is, a half period of the 2-dividied signal). Here, the 2-divided signal may correspond to the output of the first logical dividing element 311 among the logical dividing elements 310 connected in series with each other.

In the case of the 6-divided signal, the 6-divided signal may be generated by 2-dividing the 3-divided signal. Since the 5-divided signal may be implemented by one period of the 6-divided signal and one period of the 2-divided signal, the division may be performed, similar to the example of the 3-divided signal described above. This may be similarly to the 7-divided signal and the 9-divided signal.

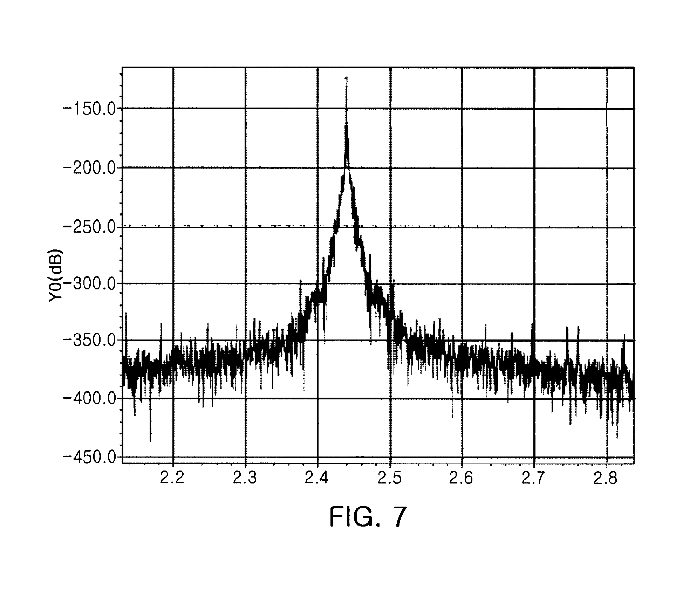

FIG. 7, which is a reference graph illustrating simulation data according to an exemplary embodiment of the present disclosure, shows performance of a phase locked loop using the digital divider according to the present disclosure.

As illustrated in FIG. 7, it may be appreciated that high performance is implemented at a required frequency in spite of using the digital divider.

As set forth above, according to exemplary embodiments of the present disclosure, the digital divider having a simple structure may be provided, and the frequency synthesizer may be configured using the digital divider, whereby miniaturization of the frequency synthesizer may be accomplished.

While exemplary embodiments have been shown and described above, it will be apparent to those skilled in the art that modifications and variations could be made without departing from the spirit and scope of the present disclosure as defined by the appended claims.

## Claims

1. A digital divider comprising:
a dividing unit including a plurality of logical dividing elements; and
a division controlling unit receiving an input signal and outputs of the plurality of logical dividing elements and outputting a divided signal generated by dividing the input signal by a predetermined dividing ratio using the outputs of the plurality of logical dividing elements.

2. The digital divider of claim 1, wherein the dividing unit is configured of a plurality of flip-flops connected in series with each other, each of the plurality of flip-flops performing 2-divisions.

3. The digital divider of claim 1, wherein the division controlling unit outputs an output of any one of the plurality of logical dividing elements as the divided signal when the dividing ratio is 2^{N}.

4. The digital divider of claim 1, wherein the division controlling unit determines the dividing ratio using a dividing ratio signal of 50% when the dividing ratio is an even number other than 2^{N}.

5. The digital divider of claim 3, wherein the division controlling unit includes a multiplexer receiving the outputs of the plurality of logical dividing elements and outputting any one of the outputs of the plurality of logical dividing elements as the dividing signal.

6. The digital divider of claim 1, wherein the division controlling unit applies an ON time during a time of N/2+0.5 and applies an OFF time during a time of N/2-0.5 when the dividing ratio is an odd number, thereby determining the odd numbered dividing ratio.

7. A frequency synthesizer comprising:
an analog circuit unit detecting differences between phases and frequencies of a reference signal and a divided signal, varying a frequency depending on the differences, and outputting an oscillation signal having the varied frequency; and
a digital circuit unit dividing an output frequency of the oscillation signal and feeding back the divided signal to the analog circuit unit.

8. The frequency synthesizer of claim 7, wherein the analog circuit unit includes:
a phase comparator receiving the divided signal and the reference signal and outputting a phase difference between the frequencies of the divided signal and the reference signal; and
a voltage controlled oscillator receiving a control signal corresponding to the phase difference and outputting a new oscillation signal depending on the control signal.

9. The frequency synthesizer of claim 8, wherein the analog circuit unit includes:
a charge pump charging or discharging charges in or from a capacitor depending on the phase difference output from the phase comparator; and
a filter generating the control signal using a current output from the charge pump.

10. The frequency synthesizer of claim 8, wherein the digital circuit unit includes a digital divider dividing an output frequency of the oscillation signal at a predetermined ratio and inputting the oscillation signal of which the output frequency is divided as the divided signal to the phase comparator.

11. The frequency synthesizer of claim 10, wherein the digital divider includes:
a dividing unit including a plurality of logical dividing elements; and
a division controlling unit receiving the oscillation signal and outputs of the plurality of logical dividing elements and outputting a divided signal generated by dividing the oscillation signal by a predetermined dividing ratio using the outputs of the plurality of logical dividing elements.

12. The frequency synthesizer of claim 11, wherein the dividing unit is configured of a plurality of flip-flops connected in series with each other, each of the plurality of flip-flops performing 2-divisions.

13. The frequency synthesizer of claim 11, wherein the division controlling unit outputs an output of any one of the plurality of logical dividing elements as the divided signal when the dividing ratio is 2^{N}.

14. The frequency synthesizer of claim 11, wherein the division controlling unit generates the dividing signal using a dividing ratio signal of 50% when the dividing ratio is an even number other than 2^{N}.

15. The frequency synthesizer of claim 11, wherein the division controlling unit applies an ON time during a time of N/2+0.5 and applies an OFF time during a time of N/2-0.5 when the dividing ratio is an odd number, thereby determining the odd numbered dividing ratio.
